# EUROPEAN PATENT SPECIFICATION

(11) **EP 0 601 101 B1**
(45) Date of publication and mention of the grant of the patent: **17.01.2001**
(21) Application number: 92919403.3
(22) Date of filing: 24.08.1992
(51) Int. Cl.: G01R 33/42

(54) **Method of designing a magnetically screened electromagnetic coil assembly**
Methode zum Entwurf einer magnetisch abgeschirmten elektromagnetischen Spulenanordnung
Procédé de conception d'un assemblage de bobines électromagnétiques blindé magnétiquement

(30) Priority: 27.08.1991 US 750809
(43) Date of publication of application: 15.06.1994
(73) Proprietor: BTG International Inc, Gulph Mills, Pennsylvania 19406 (US)
(72) Inventor: CHAPMAN, Barry L. W., Un. of Alabama at Birmingham, UAB Station, Birmingham, AL 352 (US)
(74) Representative: Davis, Norman Norbridge
(86) International application number: PCT/US92/07354
(87) International publication number: WO 93/04493

(56) References cited:
- EP-A- 0 216 590
- EP-A- 0 231 879
- EP-A- 0 365 065
- US-A- 4 853 663
- US-A- 4 974 338
- US-A- 4 978 920
- IEEE TRANSACTIONS ON MAGNETICS, vol.26, no.3, May 1990, NEW YORK, USA pages 1181 - 1188 A.K. KALAFALA: 'A Design Approach for Actively Shielded Magnetic Resonance Imaging Magnets'
- IEEE TRANSACTIONS ON MAGNETICS, vol.25, no.2, March 1989, NEW YORK, USA pages 1885 - 1888 A. ISHIYAMA ET AL.: 'Optimal Design of MRI Magnets with Magnetic Shielding'

## Description

### Field of the Invention

This invention relates to the design of magnetically screened coil assemblies.

### Background of the Invention

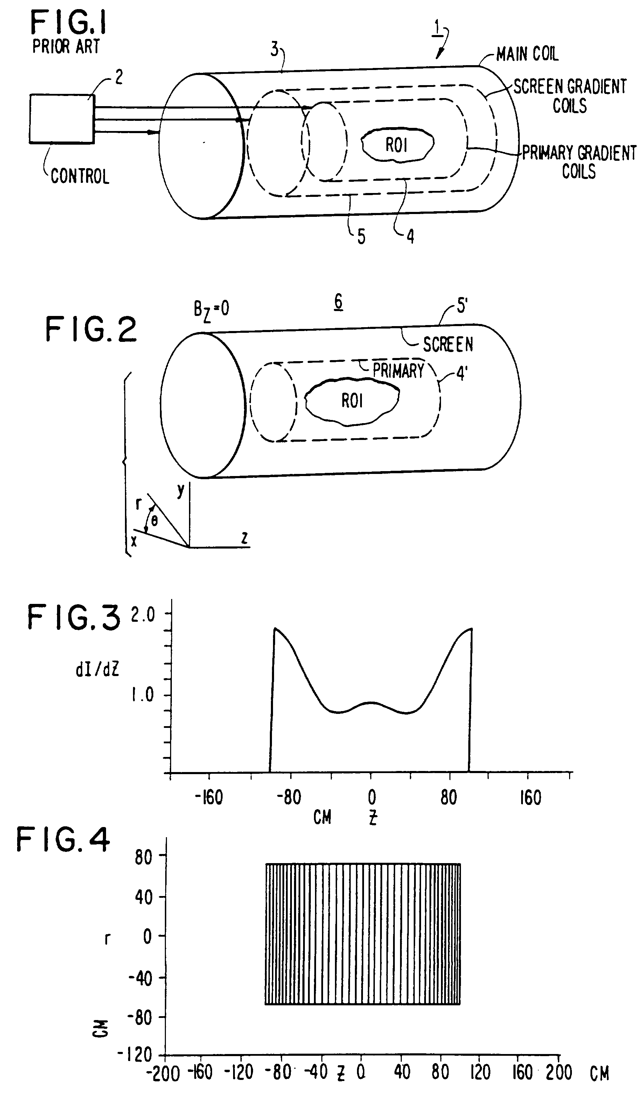

Electromagnetic coil design is of great importance in many fields of physics and engineering. This is particularly true at the present time in Nuclear Magnetic Resonance (NMR) imaging and spectroscopy where the requirement for precise spatial variation of a variety of magnetic fields is paramount. The most common arrangement of electromagnetic coil structures for use in NMR is illustrated in Figure 1 in which system 1 comprises: a control 2 for operating the system, a main coil 3, usually superconducting, which provides a large, uniform, substantially homogeneous magnetic field over a region of interest (ROI) in the center of the structure and one axial and two transverse linear gradient field coils 4 (only one being shown for purposes of illustration) that are intended to provide three orthogonal gradient fields that vary linearly over the ROI. The gradient coils shown include active screen coils 5.

Screened or shielded gradient coils, and occasionally screened main field coils, have become preferred structures for NMR systems. Active screened coils are described in an article entitled Active Magnetic screening of Gradient Coils in NMR Imaging by Mansfield et al. J. of Magnetic Resonance 66, p. 573-576 (1986) which discloses a method of systematically screening static or time-dependent stray fields. In this method extraneous magnetic fields outside the active volume of the field gradient coil systems are nulled while gradient fields of a desired type are intended to be generated in the ROI. Subsequent developments have resulted in integrated coil systems wherein primary gradient coils and screen coils cooperate with one another to produce the gradient magnetic fields in the ROI adjacent to the primary coil structure while creating the external null field. Screened coils are such that they provide for a field of a specific type, e.g., a uniform field, a linear field and so on, within the ROI adjacent to the primary coil structure while simultaneously providing a substantially zero field adjacent to the screen coil structure.

In Figure 2, a cylindrical embodiment of a prior art NMR system, the screen coil 5' and the primary coil 4' are intended to create a given desired type of field in the ROI while providing a null field Bz=O in the region external relative to screen coil 5'. Screened coils are used to eliminate time dependent eddy currents in proximal conducting structures, and hence the resultant time dependent perturbations of the magnetic field in the ROI. It is known that the inductance of screened coils is identical to that of unscreened coils providing the same primary field, since, by definition for screened coils, all flux lines return within the screen such that there is no net flux anywhere. Further, the resistance of the screen coil is also independent of the numbers of arcs (turns) that comprise it. This property results from the fact that the more turns that are present on the screen portion of the structure the proportionally greater amount of current that must be tapped off into a parallel circuit. The reduction in current in the screen is in direct proportion to the increase in the number of turns, e.g., double the turns and the current reduces to half and the voltage drop, and thus the resistance, remains constant.

Active screening also provides a means of greatly reducing the extent of the stray external field from the main coil structure which otherwise has adverse effects on all electronic devices within the local region. Consequently, it is desirable to eliminate, or at least greatly reduce, this external field. The alternative, using passive screening, requires the use of great masses of ferromagnetic material.

The significant prior art methods of approaching the general problem of electromagnetic coil design are somewhat arbitrary in their choice of a starting point for the calculation of the surface current distributions of the coils of interest. As a result the computations tend to be cumbersome, relatively slow and the resulting coils do not generate optimal fields.

The general problem of electromagnetic coil design is one of solving the Biot-Savart equation:${\text{B}}_{̲} \text{(} {\text{r}}_{̲} \text{) =} \frac{\text{µ}}{\text{4π}} \text{∫} \frac{\text{J(} {\text{r'}}_{̲} \text{)∧(} {\text{r}}_{̲} \text{-} {\text{r'}}_{̲} \text{)dτ'}}{{\left|{\text{r}}_{̲} \text{-} {\text{r'}}_{̲}\right|}^{\text{3}}}$ where B (the quantities underlined are vector quantities having three orthogonal spatial components) is the resultant magnetic field at the point r due to the current density distribution J(r') flowing at all points r' within the region of interest and µ is the magnetic permeability of the medium.

Solving the Biot-Savart equation to obtain the magnetic field for a given current distribution, in all but a few very simple cases, has until recently, relied upon numerical integration methods. Solving the reverse problem, that of determining a particular current distribution to produce a desired magnetic field, is more difficult. Frequently, and particularly in the design of electromagnets for NMR, fields are generated by coils wound upon a cylindrical former. Until recently, solutions for such coils were obtained by expanding the magnetic field in terms of spherical harmonics and optimizing the first few non-zero terms at the origin. This method has been in use for over a century and results in the standard Helmholtz and Maxwell coils for uniform and linear axial gradient coil designs, respectively. This system generates designs which are essentially a series of line current elements at particular spatial locations.

According to Ampere's law, any theoretically achievable magnetic field can be generated in a region by a current distribution on a surface enclosing that region. For cylindrical coils, this involves surfaces which are either of infinite length or are closed. For practical reasons, in NMR where access to within the coil is essential, the cylinders must be relatively short and open ended. As a result, the practically achievable magnetic fields, while better than those derived by spherical harmonic expansion, are not perfect, and exhibit distortion from the desired field parameters. Therefore, some form of optimization is necessary generally based on assumption and compromises which still result in undesired distortion of the resultant screen-primary coil generated field or compromising the null value of the external field, i.e., generating a significant stray field in the null region.

Exact solutions of the Biot-Savart equation, equation 1, which take into consideration its convoluted nature were initially derived to solve the problem of eddy current formation in structures external to gradient coils in NMR systems. These solutions have been subsequently applied to the problem of gradient coil design by Turner in 1986 in an article entitled A Target Field Approach to Optimal Coil Design, J. Phys. D:Appl. Phys. 19 (1986) L147-L151 and integrated shielded gradient coil design in an article by Mansfield et al. entitled Multishield Active Magnetic Screening in NMR, J. Mag. Resonance 72, 211-223 (1987). In these latter two cases a suitable (convergent at infinity) "target" field is chosen for the primary gradient field. The choice of such a field is completely arbitrary and does not consider the invariably finite length of the primary coil surface. This results in distortion in the resultant generated field.

In an article by Turner et al. Passive Screening of Switched Magnetic Field Gradients, J. Phys. E. Sci. Instrum. 191 (1986) p. 876-879, a thick cylinder conductor is disclosed for passive screening of magnetic field gradients. However, currents induced in the sleeves decay with uncontrolled relaxation times interfering with the NMR imaging. This is because the decaying current produces image fields superimposed on the desired gradient field introducing artifacts which can ruin the image.

An article by Mansfield et al. entitled Active Magnetic Screening of Coils for Static and Time-dependent Magnetic Field Generation in NMR Imaging J. Phys. E: Sci. Instrum. 19 (1986) p. 540-545 discloses a set of current carrying conductors or a discrete wire array to simulate the induced surface currents which occur in high conductivity thick metal screens when placed around coils producing time-dependent fields or field gradients. Strong external fields are made arbitrarily low making it feasible to generate large rapidly switched gradients within and in close proximity to a superconducting magnet which is especially useful in NMR imaging. The active screen may comprise a set of conductors or a mesh of equally spaced wires in which a current pattern is externally generated to mimic an induced surface current distribution. An alternative arrangement is one in which the screen wires carry the same current but the wire spacing is unequal. It is disclosed that the field outside the active screen is substantially nulled. However, the problem of obtaining an optimum field in the region of interest is not addressed. A disclosure corresponding to these articles appears in GB Patent 2,180,943 (EP-A-216 590). This patent discloses the active screen as a complete reflector of the magnetic field produced by a primary coil, the screen being shaped to provide an aperture for access to a volume enclosed by the screen.

European Patent EP-A-0231879 is an alternative to the above solutions and discloses optimization of a screened coil by adding terms from a second cylindrical surface. However, the length of the screen coil is a severe constraint. The use of the total available coil length is almost always unsuitable for designing the screen parameters. This is because the requisite number of harmonic wavelengths are not necessarily aliquot to this length. As a result, the fields generated by coils of this design exhibit distortion in the presence of the desired null field. A further problem with this approach is that it compromises the null field. Therefore, to eliminate the distortion in the generated field, the null field value is compromised to a non-null value, which in effect can eventually have deleterious affects on the generated field in the ROI.

### Summary of the Invention

A method according to the present invention optimizes the design of a screened electromagnetic coil assembly. In accordance with the present invention, there is provided a method of designing a magnetically screened electromagnetic coil assembly, comprising a primary coil and a screen coil, for generating a desired magnetic field in a region of interest (ROI) defined by the primary coil and a substantially null magnetic field to the side of the screen coil facing away from the primary coil, comprising the following steps:
a) setting the dimensions of the surface on which the current distribution of the primary coil is defined,
b) setting the position of the surface on which the current distribution of the screen coil is defined relative to the position of the surface on which the current distribution of the primary coil is defined,
c) assuming the screen coil is of infinite extent, such that it would act as a perfect screen,
d) calculating the magnetic field in the ROI from the unit current amplitude of a finite set of the lowest spatial frequency harmonics of the current distribution over the surface of the primary coil and assuming a current distribution in the screen coil that would give perfect screening,
e) optimising the amplitudes of said current distribution harmonics of the primary coil by the method of least squares in order to achieve a desired magnetic field in the ROI,
f) calculating the resulting current distributions in the primary coil and the screen coil,
g) selecting the positions at which the conductors of the primary coil and of the screen coil are to be placed such that the actual current distributions within the coil structure approximate the calculated current distributions,
h) limiting the extent of the screen coil where the amplitude of its current distribution becomes negligible.

Preferably, the screen coil surrounds the primary coil, with the coils being formed as cylinders. They may however have other shapes, such as flat coil forms.

### Brief Description of the Drawings:

Figure 1 is a diagrammatic representation of a prior art electromagnetic coil structure in an NMR system;
Figure 2 illustrates in diagrammatic form a generalized prior art screened coil arrangement for providing a field in one region of a given type and for providing a substantially zero external field;
Figure 3 illustrates an unscreened magnetic field coil current distribution in which the amplitude is constant in the azimuth direction normal to the drawing sheet on the surface of a cylinder optimized to provide a uniform field over a cylindrical region of interest;
Figure 4 illustrates practical means of achieving the current distribution of Figure 3 wherein the lines represent a series connected structure of conductors the spacings of which are given by equally spaced contours on the integral of the current distribution of Figure 3;
Figure 5 is a sectional elevation view of a coil construction for generating a large uniform field in which depth is proportional to current distribution; note depths have been exaggerated in comparison with the radius for purposes of illustration;
Figure 6a and 6b illustrate coupling of coil sections between successive turns of axial and transverse coil structures, respectively;
Figure 7a and 7b illustrate current distributions for respective primary and screen coil surfaces to provide a uniform magnetic field within a region of interest and a null external field;
Figures 8a and 8b illustrate respective equally spaced contours as the integrals in the axial direction of the current distribution curves of the primary and screen surfaces depicted in Figures 7a and 7b;
Figures 9a and 9b illustrate linear axial gradient magnetic field coil current distributions restricted to primary and screen cylindrical surfaces;
Figures 10a and 10b illustrate a series of equally spaced contours of the integrals of the current distribution curves of the primary and screen surfaces depicted in Figures 9a and 9b, respectively;
Figure 11a shows the substantially undistorted linear field variation Bz over a region of interest for the screened axial gradient coil current distributions shown in Figures 9a and 9b;
Figure 11b shows the distorted linear magnetic gradient field provided by a prior art Maxwell coil of equal radius to the primary coil;
Figures 12a and 12b respectively show screened linear transverse gradient magnetic field coil current distributions on primary and screen cylindrical surfaces;
Figure 13 shows iso-contours of the screened transverse gradient coil primary current distribution on a cylinder with the cylinder unrolled in the azimuth direction showing all four quadrants in accordance with an embodiment of the present invention; and
Figure 14 is an unrolled flat view of a quadrant of a screen coil current distribution in accordance with an embodiment of the present invention.

### Description of the Preferred Embodiments

In Figure 1, NMR system 1 includes a control 2 whose construction is well known and will not be further described in detail herein. The control includes the appropriate power sources including rf for energizing the coils of the system. System 1 includes a main outer coil 3 commonly used in NMR imaging systems to create a relatively large static magnet field in a region of interest (ROI), e.g., the region for receiving a patient to be examined by the NMR images. The outer coil 3 is the main coil generating the static B field for the system. Primary gradient coil 4 represents a plurality of gradient coils which generate the axial and transverse gradient fields for imaging purposes in a known way in NMR systems. The screen gradient coils (5) are the active screening coils used to cancel the fields created by the gradient coils 4 in order to screen the surrounding metal structure.

The outer coil 3 usually is superconducting and occasionally screened (not shown). This coil provides a large, uniform substantially homogeneous magnetic field over the ROI at the center of the structure. Within this magnet resides one axial and two transverse linear gradient coils represented by coils 4. Coils 4 are intended to provide three orthogonal gradient magnetic fields that vary linearly over the ROI.

Screen electromagnetic coils 5 cooperate with the gradient coils 4 to generate a magnetic field of a specific type, e.g., uniform, linear, within the ROI while simultaneously providing a substantially zero (null) field in an external region 6, Figure 2. The screen and primary coils obtain these characteristics by having requisite current distribution flowing on their primary coil and screen coil surfaces shown here in one preferred embodiment as inner and outer circular cylindrical surfaces.

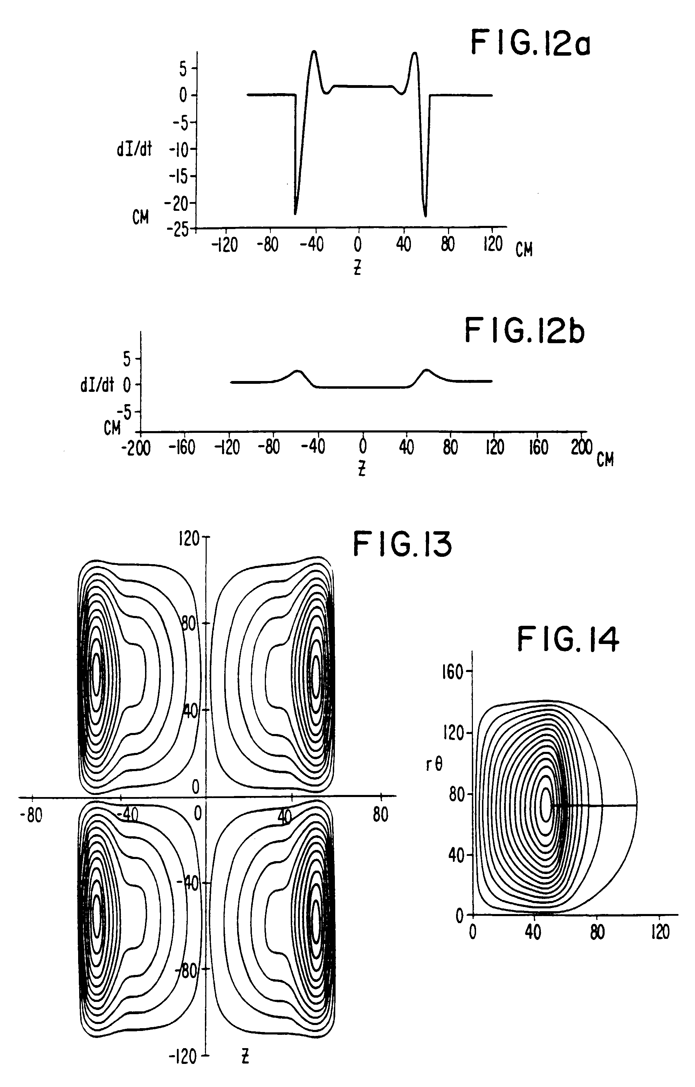

The term "distortion" herein means a field that is different than that which is intended. For example. Figure 11a illustrates a substantially linear gradient field and Figure 11b illustrates a significantly distorted field, i.e. the field is non-linear. Additionally, the open nature of the coil of interest exhibits leakage flux which is a more difficult problem to resolve than a closed coil.

European patent application EP-A-231 879 proposes a form of least squares optimization of a screened coil involving adding terms from a second cylindrical surface. However, the choice of screen length is arbitrary. The use of the total available length is almost always unsuitable as the requisite harmonic wavelengths for adequate screening are not necessarily multiples of this length. The prior methodology requires an assumption of a given screen coil length prior to performing the coil design calculations. Necessarily, this assumption is invariably incorrect.

According to the present invention, it is recognized that for purposes of calculation, the screen can be assumed to be of infinite length. As a result, a perfect screen coil can be created, i.e., one that with the primary coil creates a respectively null field in a first adjacent region and a substantially distortion free field of a given type in a second adjacent region. The current in the screen coil will diminish rapidly beyond the axial limits of the primary coil and its length can be determined retrospectively to impact insignificantly on the derived magnetic fields. As a result, no constraints are placed upon the screen coil design and the solution is readily obtained in which a more perfect screen produces a substantially zero external field as compared to prior art systems.

The Biot-Savart equation (1) states that the magnetic field B is given by the convolution of the current density distribution J, with the inverse square of the distance r/|r³|. Therefore, equation (1) can be greatly simplified by Fourier transforming to a simple product in the Fourier Kernal space:${\text{B}}_{̲} \text{(} {\text{s}}_{̲} \text{) = µ} {\text{J}}_{̲} \text{(} {\text{s}}_{̲} \text{)∧} \frac{{\text{s}}_{̲}}{{\left|{\text{s}}_{̲}\right|}^{\text{2}}}$ where B(s) is the Fourier transform of the field B(r) and J(s) is the Fourier transform of the current distribution J(r), both at the point s which is the general point of the Fourier Kernal space of that space for which r is the general point vector.

Utilizing this property permits the development of electromagnetic coils with improved gradient linearity and extent relative to the coil structure and the development of screened gradient coils. The analytic design of coils utilizing this property has up to now relied on the choice of a suitable function for the field with a somewhat arbitrary axial variation, which will satisfy the condition that the resultant current distribution diminishes to zero at infinity. Although the choice of a suitable function in the prior art approach is simple it is also arbitrary, and consequently the resultant field is less than optimal.

In NMR, the main field magnets are mostly cylindrical in form, consequently, the following analysis will be presented for cylindrical coils, though much of the analysis is equally applicable to other geometries as explained below.

### The Elementary Primary Current Hoop

Of particular importance in the solution of the Biot-Savart equation for coils wound on a cylindrical surface is the field from a hypothetical elemental current hoop of unit current amplitude which varies azimuthally as cos (mθ); i.e. the permissible azimuthal harmonic modes. For simplicity, the following is confined to the determination of the axial component of the field, which will be defined simply as B, and the corresponding azimuthal current J. The other components of the current distribution, and consequently the field magnetic components, can be immediately derived from the continuity equation Div. J=O. Taking the two Dimensional Fourier Transform (2DFT) of this gives: 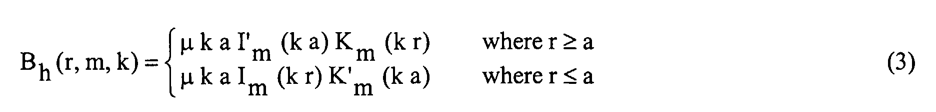 where Bₕ is the axial component of the Fourier transform in the azimuthal and axial directions of the magnetic field at radius r (not to be confused with vector position r), k is the kernal space dimension corresponding to the axial dimension z, a is the radius of the hoop, and Iₘ and Kₘ are the modified Bessel functions and I'ₘ and K'ₘ are their derivatives.

It is apparent from the foregoing that all solutions on a cylinder are simply convolutions of the elemental current hoop with a purely axial distribution function. For an open cylinder of restricted length L this current distribution can be expressed as the sum of the permissible harmonic modes, n, on the surface i.e.${\text{J}}_{\text{θ}} {\text{(a, z) = Σ}}_{\text{n}} {\text{C}}_{\text{n}} \text{H(z)cos(2πnz/L + φ)}$ where Cₙ is the current amplitude of the nth harmonic and H(z) is the unit step function given by 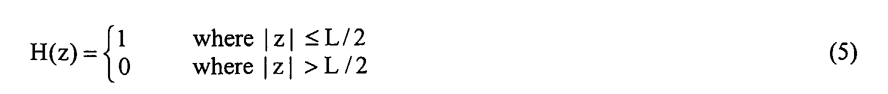 Fourier transformation of equation 4 in the z direction yields

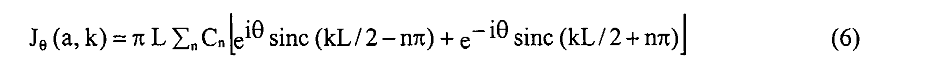

The Fourier transform of the resultant axial field in the azimuthal and axial directions is given by:${\text{B(r, m, k) = J}}_{\text{θ}} {\text{(a, k) B}}_{\text{h}} \text{(r, m, k)}$

Optimization of the coil design is then conveniently solved by least squares minimization of the first few terms (Cₙ) over the Region of Interest (ROI) in real, as against Kernal, space. The choice of the number of terms is dependent upon the geometries of the coil structure and the ROI; this can be addressed by solving with increasing numbers of terms until the cross term coefficient matrix becomes singular to, for example, one part per million, at which point no further significant improvement can be had.

### Screened Elemental Current Hoop

The resultant Fourier transform in the azimuthal and axial directions for the internal field of an implicitly screened hoop is given by:${\text{B}}_{\text{s}} {\text{(r, m, k) = µ k a I}}_{\text{m}} {\text{(kr) [K'}}_{\text{m}} {\text{(ka) - K'}}_{\text{m}} {\text{(kb) I'}}_{\text{m}} {\text{(ka)/I'}}_{\text{m}} \text{(kb)]}$ where b is the radius of the infinite screen. The external field is, by definition zero.

The permissible harmonics of the primary surface of radius a, cos(2πnz/L), which results in the axial component of the internal field for convenient two Dimensional Fourier Transform (2DFT) of which, B, is obtained by substituting Bₛ, for Bₕ in equation 7, i.e.${\text{B(r, m, k) = J}}_{\text{θ}} {\text{(a, k)B}}_{\text{s}} \text{(r, m, k)}$

Optimization of the coil design is then conveniently solved as before for the unscreened case on a least squares basis for the harmonic current amplitudes Cₙ, without the addition of any new terms. Practically, the length of the screen must be finite, but as the current distribution will fall off rapidly beyond the length of the primary coil, the screen length can be limited to the length at which the current distribution amplitude becomes negligible. In this way no a priori limitation has been imposed upon the screen that would impair, or even inhibit a solution for the coefficients. Nor will this current method compromise the screening or the field over the ROI.

A significant reduction in the number of coefficients can be achieved by incorporating an unconvoluted term in the series, i.e. adding a component representing the field from the current distribution for a flat surface. Examples are the field from a constant current distribution for when a uniform field is required, and a current distribution that varies linearly when a linear axial gradient is required.

The following is employed to determine the current distributions for either unscreened or screened coil structures.
a) Set the values for the physical constants, specifying the positions of the primary surface, and screen surface if required, the extent of the primary coil, and the ROI. The ROI is specified as a lattice of points over which the optimization is to be performed. For example, a screened cylindrical coil structure is specified by the screens radius b, the primary's radius a, and the primary's length L. A convenient ROI is a cylindrical volume. Symmetry considerations and perfect azimuthal variation permit such a cylindrical volume to be specified by p radial and q axial positions from the origin out; provided p.q > the number of unknowns Cₙ.
b) Determine the magnetic field from unit current amplitude of each of the appropriate harmonics given by the inverse Fourier transform of the individual terms of the magnetic field given in equation 7, suitably modified for screened systems. For example if a transaxial gradient is required on a cylinder only the cos(θ) azimuthal variation is required and only even longitudinal terms cos(2πnz/L), with n>0, need be considered for reasons of current continuity [return path].
c) The least squares optimization is then performed with increasing number of coefficients until no significant improvement in the field in the ROI can be obtained. For the cylindrical example 2, 3, 4 etc. terms are incorporated into the coefficient matrix until it becomes non-singular to 1 part per million (ppm), at which point no further significant improvement is to be had.
d) The significant coefficients are then used to determine the total current distribution, as given by equation 4.
e) Equipotential contours are then determined in the axial and azimuthal directions. These contours are then utilized as the basis for practical manufacture of the coil structure.

The following examples constitute the three primary fields required for the performance of NMR:
1. Uniform magnetic field
   a. Unscreened,
   b. Screened.
2. Linear axial gradient field
3. Linear transverse gradient field.

The method of the present invention is immediately applicable to similar coil geometries and all ROI's geometries. Further, the method can be readily generalized to other open geometries, for example flat surfaces.

In all of the following examples, a cylindrical ROI of diameter 55 cms radius and 40 cms length was used and least squares optimization was performed over six evenly spaced radii within it.

The choices of a cylindrical ROI and all dimensions is arbitrary.

### Unscreened Uniform Magnetic Field Coil

The design of an unscreened uniform magnetic field coil, which is not an embodiment of the present invention, is described initially to illustrate the principles employed when designing a screened coil assembly according to the invention.

For the purposes of this example a cylindrical coil structure of 140 cms diameter restricted to a length of 200 cms is assumed.

Least squares optimization over the ROI was achieved in the manner described above with he first three harmonic terms CO, C1, and C2. Figure 3 shows the unscreened magnetic field coil current distribution (Mega Amps per Meter per Tesla versus cms) on the surface of a cylinder of diameter 140 cms and length 200 cms, optimized to provide a uniform field on a cylindrical ROI of diameter 55 cms and length 40 cms. The figure shows the current distribution that will provide such a uniform magnetic field; the amplitude of this current distribution being constant in the azimuthal direction. This distribution can be achieved by the suitable placement of conductors by a method as described in the literature. The two most common embodiments of which are the use of either conductors of uniform cross section or equally spaced conductors of varying width in the axial direction, both wound azimuthally and in series. In both cases the thickness of the conductors is assumed to be small compared to the diameter of the coil.

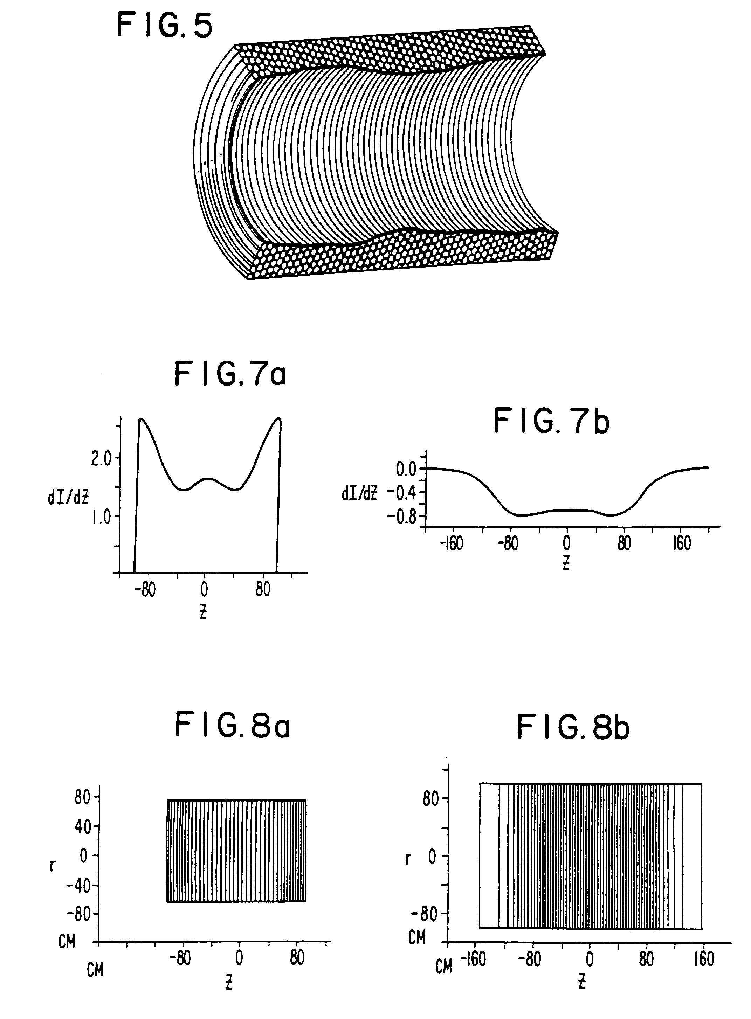

One means of practically achieving the uniform field is to place series wound conductors of uniform thickness along the lines indicated on the diagram, Figure 4. A second means of achieving the field is to place conductors of thickness corresponding to the spacing between lines, again connected in series; in which case the lines become the spacing between each 'loop' of the coil. Figure 4 shows a side view of the coil arrangement with 40 or 41 turns for the conductors of uniform and none uniform thickness respectively; the two extra turns in the latter case are formed by the ends of the structure which is shown here open. The front view of the structure is circular. In a practical embodiment the number of turns for the main field would be several orders of magnitude more than those depicted, and the use of uniform wires wound in such a way as to form a depth corresponding to the current distribution, Figure 5, with a compensation, not shown, for the depth, would be a convenient means of achieving it.

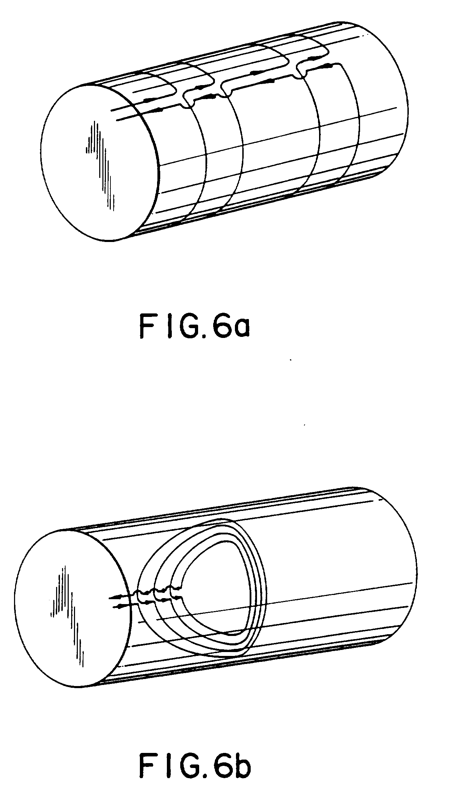

The contribution from connecting sections between successive turns can be made negligible by placing return paths adjacent to incoming lines, Figures 6a and 6b.

### Screened Uniform Magnetic Field Coils

For the purpose of this example a cylindrical coil structure of 140 cms diameter restricted to a length of 200 cms is assumed for the primary, and a cylindrical coil structure of 200 cms diameter for the screen.

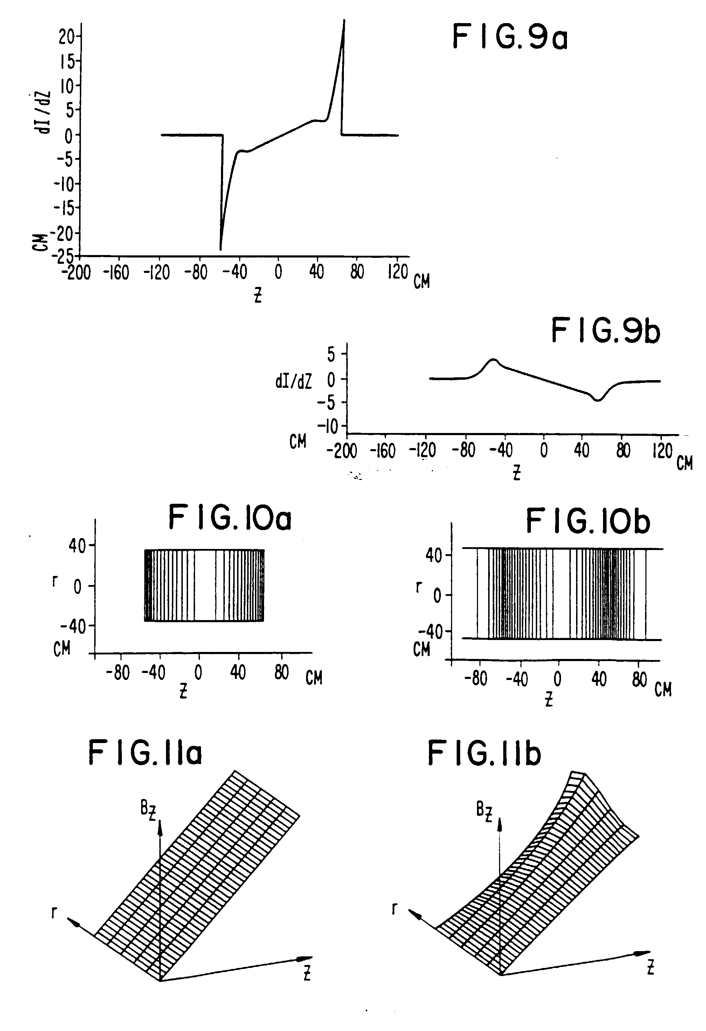

Least squares optimization over the ROI is achieved with the first three harmonic terms; as expected. Figures 7a and 7b show the current distribution for the primary, 7a, and screen, 7b, that will simultaneously provide such a uniform magnetic field within the ROI and zero field external to the screen (r > 100 cms); the amplitudes of both current distributions are constant in the azimuthal direction. These distributions can be achieved in an identical manner to that proposed for the unscreened coil of la above.

Figures 8a and 8b show a series of equally spaced contours on the current distribution curves of the primary and screen surfaces respectively.

### Screened Linear Axial Gradient Magnetic Field Coil

For the purpose of this example a cylindrical coil structure of 70 cms diameter restricted to a length of 120 cms is assumed for the primary, and a diameter of 90 cms for the screen.

Least squares optimization over the ROI resulted in the current distributions shown in Figures 9a and 9b for the primary and screen, respectively. The corresponding equipotential contours, or equally coil windings, are respectively shown in Figures 10a and 10b. These current distributions provide a magnetic field which varies linearly with distance along the axis in the ROI, Figure 11a, and a zero field external to the screen (r>45 cms); the amplitudes of both current distributions are constant in the azimuthal direction. For comparison purposes Figure 11b shows the distorted linear magnetic gradient field provided by a prior art Maxwell coil arrangement of equal radius to the primary coil.

### Generalized Solution

The foregoing has concentrated on the application of solutions over a specific ROI. For each ROI the problem must be reworked. As with the designs based on spherical harmonics, solutions exist which are scale independent, provided some loss of optimization is tolerated. A general solution can be achieved for surface current distributions by determining the current distribution required to provide the desired field at the surface of the conductor. The resultant design can subsequently be scaled. Such a solution is akin to the effect of introducing super conducting surfaces, or highly conductive ones, into a magnetic field, or rapidly changing ones respectively, for the design of unscreened gradient coils as discussed in EP-A-216 590.

This general 'super-conducting' solution, which does not fall within the scope of the present claims, can be obtained with an iterative procedure starting from a current distribution which is simply proportional to the magnetic field required, as in the case of solutions for a flat surface, i.e. where successive approximations for the current distribution J are given by:${\text{J}}_{\text{n+1}} {\text{= J}}_{\text{n}} {\text{(B-B}}_{\text{n}} \text{)/µ}$ where B is the desired field at the surface and Bₙ is the field from the current distribution Jₙ.

The least squares optimization for screened coil design according to the present invention has the advantage that it can be utilized for surfaces of arbitrary shape. The problem becomes more complicated with the loss of symmetry and the need to specify shapes of increasing degrees of arbitrariness in three dimensions. The general, iterative 'super-conducting' process described above also shares these advantages and disadvantages when applied to structures of increasingly arbitrary surface configuration.

Though no effort have been made to minimize the inductance, this system produces coils for which the inductance differs only slightly from the minimal. In addition, this minimization can be incorporated into coils designed according to the present invention, but only at some cost of field optimization.

It is anticipated that this invention can be implemented in all aspects of electromagnet design where external fields are undesirable. For example, it may have applications in particle accelerators and for the protection of electronic circuitry, such as computers, proximate to large magnetic fields. Also, it is expected that the combination of the precise profiling of magnetic fields and the suppression of extraneous fields will become increasingly important with the advancements of superconductor magnet technology, and particularly with the development of higher temperature superconducting materials.

### Flat Coils

If the plane of the current distribution, J, is defined to be normal to the x axis then Fourier Transformation of the Biot-Savart equation (1) in the two dimensions (y, z) gives:${\text{B}}_{̲} \text{(x, v, w) = µ} \frac{{\text{e}}^{\text{-|x|q}}}{\text{2}} {\text{J}}_{̲} \text{(v, w)} {\text{g}}_{̲}$ where 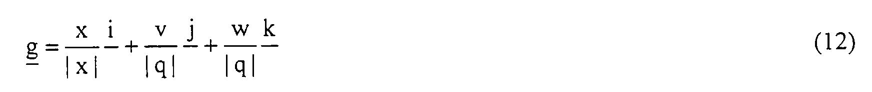 and${\text{q = (v}}^{\text{2}} {\text{+ w}}^{\text{2}} {\text{)}}^{\text{½}}$ where v and w are the Fourier kernal dimensions corresponding to y and z, respectively.

The solutions for any particular restricted geometric shape, rectangular, circular, elliptical etc., can again be derived by simply considering the permissible harmonic modes.

## Claims

1. A method of designing a magnetically screened electromagnetic coil assembly, comprising a primary coil and a screen coil, for generating a desired magnetic field in a region of interest (ROI) defined by the primary coil and a substantially null magnetic field to the side of the screen coil facing away from the primary coil, comprising the following steps:
a) setting the dimensions of the surface on which the current distribution of the primary coil is defined,
b) setting the position of the surface on which the current distribution of the screen coil is defined relative to the position of the surface on which the current distribution of the primary coil is defined,
c) assuming the screen coil is of infinite extent, such that it would act as a perfect screen,
d) calculating the magnetic field in the ROI from the unit current amplitude of a finite set of the lowest spatial frequency harmonics of the current distribution over the surface of the primary coil and assuming a current distribution in the screen coil that would give perfect screening,
e) optimising the amplitudes of said current distribution harmonics of the primary coil by the method of least squares in order to achieve a desired magnetic field in the ROI,
f) calculating the resulting current distributions in the primary coil and the screen coil,
g) selecting the positions at which the conductors of the primary coil and of the screen coil are to be placed such that the actual current distributions within the coil structure approximate the calculated current distributions,
h) limiting the extent of the screen coil where the amplitude of its current distribution becomes negligible.

2. The method of claim 1 wherein the screen coil surrounds the primary coil, the primary coil embraces the ROI, and the null magnetic field is everywhere outside the screen coil.

3. The method of claim 1 or 2 wherein said coils are cylindrical.

4. The method of claim 1 wherein said coils are flat coils.

5. The method of any of the preceding claims wherein the conductors are positioned at equipotential contours of the current distributions.

## Patentansprüche

1. Ein Verfahren zum Auslegen einer magnetisch abgeschirmten elektromagnetischen Spulenanordnung, die eine Primärspule und eine Schirmspule umfaßt, zum Erzeugen eines gewünschten magnetischen Feldes in einem im Interesse stehenden Bereich (ROI), der von der Primärspule definiert ist, und eines im wesentlichen nicht vorhandenen Magnetfeldes an der Seite der Schirmspule, die von der Primärspule abgewandt ist, das die folgenden Schritte aufweist:
a) Vorgeben der Abmessungen der Fläche, auf der die Stromverteilung der Primärspule definiert ist,
b) Vorgeben der Position der Fläche, an der die Stromverteilung der Schirmspule definiert ist, relativ zu der Position der Fläche, auf der die Stromverteilung der Primärspule definiert wird,
c) Voraussetzen, daß die Schirmspule unendlich ausgedehnt ist, so daß sie als perfekte Abschirmung dienen würde,
d) Berechnen des magnetischen Feldes in dem ROI aus der Einheitsstromamplitude einer finiten Gruppe der niedrigsten räumlichen Frequenzharmonischen der Stromverteilung über der Fläche der Primärspule und Annehmen einer Stromverteilung in der Schirmspule, die eine perfekte Abschirmung ergeben würde,
e) Optimieren der Amplituden der Stromverteilungsharmonischen der Primärspule mittels des Verfahrens der kleinsten Quadrate, um ein gewünschtes Magnetfeld in dem ROI zu erhalten,
f) Berechnen der resultierenden Stromverteilungen in der Primärspule und der Schirmspule,
g) Auswählen der Positionen, an denen die Leiter der Primärspule und der Schirmspule anzuordnen sind, so daß sich die tatsächlichen Stromverteilungen in der Spulenstruktur den berechneten Stromverteilungen annähern,
h) Begrenzen des Bereichs der Schirmspule, wo die Amplitude ihrer Stromverteilung vernachlässigbar wird.

2. Das Verfahren gemäß Anspruch 1, bei dem die Schirmspule die Primärspule umgibt, die Primärspule den ROI umfaßt und das magnetische Nullfeld überall außerhalb der Schirmspule vorliegt.

3. Das Verfahren gemäß Anspruch 1 oder 2, bei dem die Spulen zylindrisch sind.

4. Das Verfahren gemäß Anspruch 1, bei dem die Spulen flache Spulen sind.

5. Das Verfahren gemäß einem der vorhergehenden Ansprüche, bei dem die Leiter an Konturen gleichen Potentials der Stromverteilungen angeordnet sind.

## Revendications

1. Procédé de conception d'un ensemble de bobine électromagnétique blindé magnétiquement, comprenant une bobine principale et une bobine de blindage, pour générer un champ magnétique désiré dans une région intéressante (ROI) définie par la bobine principale et un champ magnétique sensiblement nul sur le côté de la bobine de blindage tourné à l'écart de la bobine principale, comprenant les étapes consistant à :
a) établir les dimensions de la surface sur laquelle la distribution de courant de la bobine principale est définie,
b) établir la position de la surface sur laquelle la distribution de courant de la bobine de blindage est définie par rapport à la position de la surface sur laquelle la distribution de courant de la bobine principale est définie,
c) supposer que la bobine de blindage est de dimension infinie de sorte qu'elle agirait comme un blindage parfait,
d) calculer le champ magnétique de la région ROI à partir de l'amplitude de courant unité d'un ensemble fini des harmoniques de fréquence spatiale les plus inférieurs de la distribution de courant sur la surface de la bobine principale et supposer une distribution de courant dans la bobine de blindage qui donnerait un blindage parfait,
e) optimiser les amplitudes desdits harmoniques de distribution de courant de la bobine principale par la méthode des moindres carrés afin d'obtenir un champ magnétique désiré dans la région ROI,
f) calculer les distributions de courant résultantes dans la bobine principale et la bobine de blindage,
g) sélectionner les positions auxquelles les conducteurs de la bobine principale et de la bobine de blindage doivent être placés pour que les distributions de courant réelles dans la structure de bobine s'approchent des distributions de courant calculées,
h) limiter l'étendue de la bobine de blindage là où l'amplitude de sa distribution de courant devient négligeable.

2. Procédé selon la revendication 1, dans lequel la bobine de blindage entoure la bobine principale, la bobine principale renferme la région ROI, et le champ magnétique nul est partout à l'extérieur de la bobine de blindage.

3. Procédé selon la revendication 1 ou 2, dans lequel lesdites bobines sont cylindriques.

4. Procédé selon la revendication 1, dans lequel lesdites bobines sont des bobines plates.

5. Procédé selon l'une quelconque des revendications précédentes, dans lequel les conducteurs sont positionnés sur des contours d'équipotentiel des distributions de courant.
